Europäisches Patentamt

European Patent Office

Office européen des brevets

(11) Publication number: **0 280 587**
A1

# EUROPEAN PATENT APPLICATION

(21) Application number: 88400099.3

(22) Date of filing: 18.01.88

(51) Int. Cl.⁴: **H 01 L 21/76**
H 01 L 21/32, H 01 L 21/00

(30) Priority: 20.01.87 US 4655

(43) Date of publication of application:
31.08.88 Bulletin 88/35

(84) Designated Contracting States:
DE ES FR GB IT NL

(71) Applicant: THOMSON COMPONENTS-MOSTEK CORPORATION
1310 Electronics Drive
Carrollton Texas 75006 (US)

(72) Inventor: Han, Yu-Pin
7701 Scotia Drive
Dallas Texas (US)

Liou, Fu-Tai
11700 Barchetta Drive
Austin Texas (US)

Bryant, Frank R.
2125 Crestwood
Denton Texas (US)

(74) Representative: Ballot, Paul Denis Jacques et al
Cabinet Ballot 84, avenue Kléber
F-75116 Paris (FR)

(54) Spacer masked VLSI process.

(57) In a VLSI process, a first layer, typically of silicon nitride over an oxide-coated surface of a silicon substrate, is anisotropically etched fo form a pattern of openings having side walls. Then a second masking layer, typically also of silicon nitride, is deposited over the first layer, filling the openings and thickening the first layer. The second layer is then anisotropically etched back to the first layer thickness, thereby reopening the original openings but with reduced dimensions because of spacer portions of the second layer left along the side walls of the opening. In a modified process, a buffer layer is deposited over the first layer before deposit of the second layer. The process can be used either for forming openings in a layer to be used for masking diffusion, ion implantation or local oxidation or for forming vias in a spacer layer to be filled with a contact metal.

FIG. 1

EP 0 280 587 A1

Description

SPACER MASKED VLSI PROCESS

FIELD OF THE INVENTION

This invention relates to the fabrication of semiconductive integrated circuits.

BACKGROUND OF THE INVENTION

In the fabrication of integrated circuits, the emphasis is on increasing components density in the circuit by decreasing component size. Decreasing component size requires improved techniques for increasing the detail in the masks or patterned layers used to control the various processing steps characteristic of the manufacturing process.

Of particular interest in VLSI processes are patterned layers.

Such layers have a variety of applications. For example, such layers can be used as masks for controlling processes, such as vapor-solid diffusion, ion implantation and local oxidation. Additionally, such layers can be used to provide dielectric isolation between different conducting levels in a semiconductive device, where the layer is patterned to provide via holes.

It will be convenient to discuss the invention with particular emphasis on the treatment of silicon nitride layers which are especially useful in VLSI processes, but the invention is not so limited. Typically, photolithography has been used to control the patterning of detail in silicon nitride layers. Such technique involves the deposition over the silicon nitride of a photoresist to serve as a mask, optically patterning the photoresist which can be either of the positive or negative type, and then using the patterned photoresist to etch correspondingly the underlying silicon nitride, typically by anisotropic reactive ion etching (RIE).

In practice, it is found difficult to achieve openings of submicron size, for example lines of 0.5 micron width, reliably by such technique, because such dimensions strain the resolution capabilities of commercial equipment available for photolithography.

An object of the invention is an improved technique for forming sub-micron opening in a masking process with spacer technique.

SUMMARY OF THE INVENTION

A method in accordance with a first embodiment of the invention involves first forming over a layer of the material, which is to be apertured, for example, silicon nitride, a pattern of openings corresponding to the final pattern desired, although larger than desired in the end product.

Thereafter, a second layer is deposited uniformly over the apertured first layer to fill its apertures and to increase its thickness where it was unapertured. The result is subjected to an anisotropic etching process uniformly to reduce its thickness until the etching has reopened the layer. However, because the second layer has thickened the region at the edges of the original opening, the size of the new opening formed by the anisotropic etching is reduced by virtue of spacers formed by the second layer at such edges. In a process of this kind using only two layers, it is advantageous to utilize the same masking material for the two layers, each typically silicon nitride if a silicon nitride mask is desired.

However, increased control can be achieved by inclusion of a buffer layer of a different material between the two nitride layers. Such a layer can be useful to provide a higher step at the edges of the original opening which in turn will lead to a better profile for the nitride spacers formed at the edges after the anisotropic etch. Additionally, such a buffer layer facilitates end-point detection of the anisotropic etch by providing a larger area for detecting the end point.

The orientation to the normal of the openings in the end product can be controlled by correspondingly shaping the original openings. Vertical side walls are generally desirable when the apertured layer is used as a mask either for localized etching of an underlying layer, for ion implantation or for local oxidation. Tapered side walls are more often desirable when the apertured layer is used as a dielectric spacer between conducting layers and the openings are used as vias for electrical contacts.

BRIEF DESCRIPTION OF THE DRAWING

In the drawing, FIGS 1-4 illustrate the workpiece at various points of a first embodiment of a process in accordance with the invention, FIGS 5 - 7 illustrate the workpiece at various points of a second embodiment of the invention, and FIGS 8-11 illustrate the workpiece at various points of a third embodiment of the invention.

It should be appreciated that the drawings are not to scale and they depict only a small portion of typically a much larger workpiece.

DETAILED DESCRIPTION OF EMBODIMENTS OF THE INVENTION

With reference now to the drawing, there is shown in section a portion of a much larger silicon chip 11 which serves as the workpiece and in which there is to be formed a number of integrated circuit devices.The invention will be described with reference to opening apertures of prescribed dimensions in a silicon nitride layer which is to be used as a mask in processing the silicon chip for forming integrated circuits therein. For the sake of simplicity, the drawing will show only a small portion of the chip in which only one opening will be formed in the overlying silicon nitride layer.

The silicon nitride layer 12 which is to be apertured typically is formed over a thin thermalyl-grown silicon oxide film 14 about 200 Angstroms thick to serve as a buffer layer between the silicon nitride and the chip. The film also will serve to provide end-point detection of the etching steps. The silicon nitride can be about 800 Angstroms thick and can be deposited in any convenient fashion, typically either by chemical vapor deposition or by a radio-frequency plasma process.

The nitride film 12 is now patterned to provide openings of which only one has been shown in the limited portion of the chip. This opening 16 is made to have vertical side walls 18 and to have the general shape of the final opening desired in the mask. Usually it will be desirable to make this openingg as small as can be reliably made by conventional processing. A typical dimension of the opening might be 1 micron wide.

Conventional processing typically comprises depositing of a photoresist, optically irradiating the photoresist covered chip through a patterned mask to modify correspondingly the photoresist, and then etching the photoresist to pattern it correspondingly. After the photoresist is appropriately patterned, it is used as a mask to etch correspondingly the underlying nitride. Reactive ion etching is a known technique for etching away the exposed nitride anisotropically to leave substantially vertical side walls for the openings in the nitride. The oxide underlying the nitride can be used as a stop for the etching.

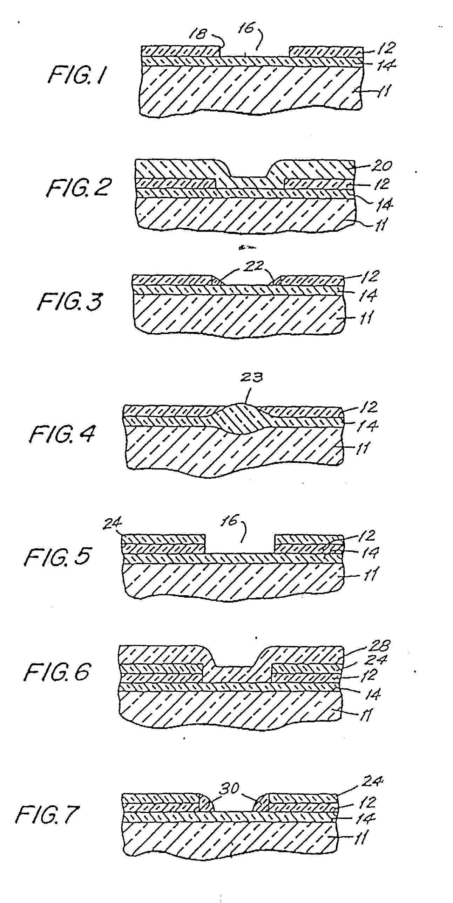

Next, there is deposited a second layer 20 of silicon nitride over the chip to fill the opening 16 and to build up the thickness of the silicon nitride elsewhere as depicted in FIG. 2. Conventional techniques can again be used to deposit such second nitride layer.

For example, a second layer of about 2,500 Angstroms thick is used to reduce the width from about 1.0 micron opening to about 0.5 micron.

The resulting workpiece is next subjected to another etching operation, this time anisotropic etching to reduce uniformly the thickness of the silicon nitride. This can be a plasma etching process designed to be anisotropic in known fashion. This etching is continued until the oxide layer is reached by etching through the thinnest region of the nitride layer, at which time there will be reached the structure shown in FIG.3 in which the second layer will have been largely removed, leaving only the spacer portions 22 along the side walls 18 of the original opening 16. Such spacers 22 will tend to extend into the opening approximately the original thickness of the second layer because of the anisotropic nature of the etching used to remove the second layer. Now that the opening has been reduced in size it can be used for the further processing of the chip in the usual fashion. For example, the apertured silicon nitride can be used as a mask in an ion implantation step common in VLSI technology for modifying the properties of the silicon substrate where the ions are implanted. Alternatively, or additionally, it can be used as a mask for forming a localized field oxide region, a step common in LOCOS technology. Such local oxidation typically would follow an ion implantation step to heavily dope the silicon region underlying such localized oxide region.

In FIG 4, there is shown the result after formation of such a localized field oxide. Such oxide is formed simply by heating the workpiece shown in FIG 3 in an oxidizing atmosphere for the time necessary to grow the oxide to a desired thickness. Such oxide typically will develop the bird's beak configuration depicted. The invention makes it easy to localize oxide regions less than 1.0 micron wide.

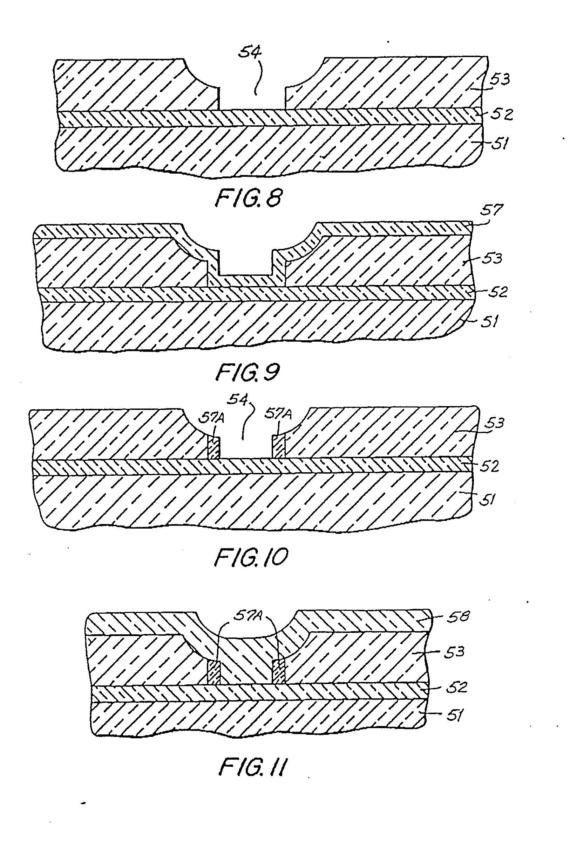

FIGS. 5 and 6 illustrate a modification of the process just described. In this modification before the deposit of the second nitride layer, there is formed a layer 24 over the layer 12. This layer 24 may be an oxide layer deposited by CVD or a polycrystalline silicon layer. Various techniques will be apparent to the worker for forming such an apertured dual layer of layers 12 and 24. Typically this can be formed by first forming the silicon nitride layer and then depositing over it the silicon oxide or polysilicon layer. Then the latter layer is first patterned to provide the desired opening 16, with vertical side walls. Then the apertured top layer is used as a mask similarly to aperture the underlying silicon nitride layer, to achieve the structure shown in FIG.5. Alternatively, after forming the triple silicon oxide, silicon nitride silicon oxide layer, they may all be etched in a single R. I. E. process to get through to the underlying silicon.

Then the second nitride layer 28 is deposited as in the previous process to fill the opening and achieve the structure shown in FIG 6. Again the thickness of the second nitride layer is chosen in accordance with the amount of closing of the opening desired. Finally the resulting structure is subjected to anisotropic etch to remove the thickness of the second nitride layer, to leave the structure shown in FIG 7 with the nitride spacers portions 30 remaining along the side walls of the opening to narrow the size of the opening, as in the earlier process.

In one example of this embodiment, the first oxide layer 14 was about 200 angstroms thick ; the first nitride layer 12, 800 Angstroms thick ; and the second nitride layer 28 about 2,500 Angstroms thick. By this technique an opening in the first two layers about 1.2 micron wide was narrowed by means of the wall spacers 30 to about 0.8 micron in which was formed a field oxide layer 5,000 Angstroms thick.

As a further embodiment, with reference to FIGS 8-11, there will described a process for forming an opening having sloped or vertical side walls in a layer useful as a dielectric spacer, the sloped or vertical opening serving as a via window through the layer. In FIG 8, there is shown a silicon chip 51 over whose surface lies a layer 52 of conducting material to which an electrical connection is to be made. Such material, for example, may be a first level metal, such as aluminium, in a two level metallization system, a silicide, a barrier layer consisting of a TiN-TiSi mixture, or simply a heavily doped region of the silicon chip. This layer 52 then is covered with a layer 53 of the material to be used as a dielectric, such as silicon dioxide, which has been deposited in the usual fashion and which has been apertured to form an opening 54 whose side walls include a sloped or tapered portion as shown. Various techniques are known for achieving such a side wall, typically involving a combination of isotropic and anisotropic reactive ion etching steps. Thereafter the layer 53 is covered with a layer 57 of material which has different etching characteristics such a silicon nitride or a polyoxide, filling the aperture 54, as shown in FIG 9. The thickness of this layer, as before, is chosen to be about one half the amount by which the size of the opening 54 is effectively to be narrowed, as in the earlier examples. Finally, the chip is exposed to anisotropic etching process to remove the layer except for spacer portions 57A which are left on the side walls of the opening 54 as shown in FIG 10.

When this technique is used for forming a contact hole in an oxide film through which contact is to be made to a localized region of the surface portion of the silicon chip, the added spacers on the side walls of the opening provide some protection against misalignment of the original opening since it provides extra insulating material to narrow the opening.

Thereafter a layer 58 of the contact metal would be deposited over the layer 53, filling the window for contacting the exposed surface of the underlying material, and this layer would then be patterned in the usual fashion, to leave contact metal in the window to which is attached the lead portion of the metal layer.

It can be appreciated that various modifications are further possible consistent with the basic principles of the invention. In particular, other combinations of materials can be used so long as they have the properties required to achieve the desired narrowing of the opening in th masking or spacer layer.

Moreover, while the invention has been discussed specifically in connection with the processing of silicon as the semiconductor, it is applicable similary to other semiconductors, such as germanium and gallium arsenide.

## Claims

1 - A process for forming narrow relatively thick field silicon oxide regions in a continuous layer otherwise of relatively thin silicon oxide over a silicon substrate comprising the steps of

- forming a continuous relatively thin oxide layer over the silicon substrate,

- forming a continuous first silicon nitride layer over said continuous silicon oxide layer,

- patterning the first silicon nitride layer to form openings where the relatively thick field oxide regions are to be formed,

- depositing a continuous second silicon nitride layer of thickness greater than the first silicon nitride layer over the patterned first silicon nitride layer for filling the openings.

- thinning anisotropically by reactive ion etching the second nitride layer for forming openings narrowed by sidewall spacers left by the second nitride layer in the filled openings for exposing the underlying silicon oxide in the openings,

- and heating the substrate in an oxidizing atmosphere for a time and at a temperature to fill the narrowed openings with relatively thick regions of silicon oxide for serving as the narrow relatively thick field oxide regions.

2 - The process of claim 1 further characterized in that the first silicon nitride layer is about 800 Angstroms thick and the second silicon nitride layer is several thousand Angstroms thick.

3 - The process of claim 2 further characterized in that the continuous silicon oxide layer has a thickness of at least several thousand Angstroms thick at the relatively thick narrow field oxide regions and a thickness of about several hundred Angstroms otherwise.

4 - The process of claim 3 in which the width of the narrow field oxide regions is less than a micron.

5 - A silicon wafer for use in the manufacture of the silicon devices comprising :

. a silicon substrate

. a continuous silicon oxide overlying the silicon substrate and including relatively thin regions overlying positions of the substrate where active devices are to be formed and relatively thick narrow field oxide regions, and

. a silicon nitride layer overlying the silicon oxide layer apertured for enclosing the relatively thick field oxide regions,

the relatively thick field oxide regions having a thickness of at least several thousand Angstroms and a width of less than one micron.

0280587

FIG. 1

FIG. 2

FIG. 3

FIG. 4

FIG. 5

FIG. 6

FIG. 7

FIG. 8

FIG. 9

FIG. 10

FIG. 11

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PATENT ABSTRACTS OF JAPAN, vol. 9, no. 147 (E-323)[1870], 21st June 1985; & JP-A-60 27 144 (TOSHIBA K.K.) 12-02-1985 --- | 1-6 | H 01 L 21/76<br>H 01 L 21/32<br>H 01 L 21/00 |
| A | PATENT ABSTRACTS OF JAPAN, vol. 8, no. 185 (E-262)[1622], 24th August 1984; & JP-A-59 76 443 (TOSHIBA K.K.) 01-05-1984 --- | 1-6 | |
| A | PATENT ABSTRACTS OF JAPAN, vol. 7, no. 144 (E-183)[1289], 23rd June 1983; & JP-A-58 57 737 (MATSUSHITA DENKI SANGYO K.K.) 06-04-1983 --- | 1-6 | |
| A | PATENT ABSTRACTS OF JAPAN, vol. 10, no. 213 (E-422)[2269], 25th July 1986; & JP-A-61 51 843 (MITSUBISHI ELECTRIC CORP.) 14-03-1986 --- | 1-6 | |
| A | IBM TECHNICAL DISCLOSURE BULLETIN, vol. 24, no. 7A, December 1981, pages 3389-3391, New York, US; A.P. HO et al.: "Self-aligned "framed" recessed-oxide-isolation process" * Figures 1-3 * ----- | 1-6 | **TECHNICAL FIELDS SEARCHED (Int. Cl.4)**<br><br>H 01 L |

The present search report has been drawn up for all claims

| Place of search | Date of completion of the search | Examiner |
|---|---|---|
| THE HAGUE | 14-05-1988 | VANCRAEYNEST F.H. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P0401)